(19) Europäisches Patentamt
European Patent Office
Office européen des brevets

(11) Veröffentlichungsnummer: **0 033 896**
**B1**

(12) **EUROPÄISCHE PATENTSCHRIFT**

(45) Veröffentlichungstag der Patentschrift: **04.01.84**

(21) Anmeldenummer: **81100582.6**

(22) Anmeldetag: **28.01.81**

(51) Int. Cl.³: **C 08 G 18/08**, C 08 G 18/83, C 08 G 85/00, C 09 D 5/02, D 04 H 1/64, C 08 F 8/34, C 08 F 2/46

(54) **Strahlungshärtbare wässrige Bindemitteldispersionen, Verfahren zu ihrer Herstellung und ihre Verwendung.**

(30) Priorität: **11.02.80 DE 3005036**

(43) Veröffentlichungstag der Anmeldung: **19.08.81 Patentblatt 81/33**

(45) Bekanntmachung des Hinweises auf die Patenterteilung: **04.01.84 Patentblatt 84/1**

(84) Benannte Vertragsstaaten: **BE DE FR GB NL**

(56) Entgegenhaltungen:
**FR - A - 1 284 015**
**GB - A - 1 072 658**
**GB - A - 2 030 573**

**Die Akte enthält technische Angaben, die nach dem Eingang der Anmeldung eingereicht wurden und die nicht in dieser Patentschrift enthalten sind.**

(73) Patentinhaber: **BASF Aktiengesellschaft, Carl-Bosch-Strasse 38, D-6700 Ludwigshafen (DE)**

(72) Erfinder: **Lehner, August, Wachenheimer Strasse 4, D-6701 Roedersheim-Gronau (DE)**
Erfinder: **Buethe, Ingolf, Dr., Seckenheimer Strasse 11 - 13, D-6800 Mannheim (DE)**
Erfinder: **Heil, Guenter, Dr., Dirmsteiner Weg 41, D-6700 Ludwigshafen (DE)**
Erfinder: **Lenz, Werner, Dr., Heinrich-Baermann-Strasse 14, D-6702 Bad Duerkheim (DE)**
Erfinder: **Hartmann, Heinrich, Dr., Weinheimer Strasse 46, D-6703 Limburgerhof (DE)**

**EP 0 033 896 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Strahlungshärtbare wässerige Bindemitteldispersionen, Verfahren zu ihrer Herstellung und ihre Verwendung

Die vorliegende Erfindung betrifft strahlungshärtbare wässerige Bindemitteldispersionen, die im wesentlichen aus Wasser und einem in Wasser dispergierten polymerisierbaren Bindemittel bestehen und gegebenenfalls einen Photoinitiator enthalten, ein Verfahren zu ihrer Herstellung und ihre Verwendung. Diese emulgatorfreien anionischen Bindemitteldispersionen enthalten die anionische Gruppe über Schwefelbrücken an das Polymere gebunden.

Wässerige Systeme als umweltfreundliche Beschichtungsmittel sind hinreichend bekannt. Auch wegen der ständig steigenden Lösungsmittelpreise gewinnt ihr Einsatz zunehmend an Interesse. Konventionelle Wasserlacke haben jedoch den Nachteil, das vielfach schon bei Schichtdicken ab 30 µm Oberflächenstörungen durch Kochblasen auftreten. Eine weitere Erhöhung der Schichtdicke um nur einige Mikrometer lässt sich nur durch komplizierte Aufheizprogramme oder durch Zusatz beträchtlicher Mengen an Cosolvenzien (20 Gew.-% und mehr) erzielen. Ersteres ist sehr zeitraubend und kostenintensiv, letzteres bedeutet eine erneute Umweltbelastung.

In der NL-C Nr. 7507052 werden anionische wässerige Emulsionen beschrieben, die aus strahlungshärtbaren Lackbindemitteln durch Neutralisation von Carboxylgruppen mit Alkalilaugen, Ammoniak oder Aminen hergestellt sind.

Kationische wässerige Dispersionen werden in der DE-A Nr. 2650782 beschrieben. Diese Polymeren zeigen jedoch eine Verdickerwirkung. Das bedingt eine Viskositätserhöhung oder bei gegebener Viskosität eine Erniedrigung des Feststoffgehaltes.

Aus den Patentschriften NL-C Nr. 6714979, BE-A Nrn. 709564 und 709565 sind strahlungshärtbare wässerige Emulsionspolymerisate bekannt. Emulsionspolymerisate sind jedoch auf Additionspolymere, beispielsweise Polyacrylate, beschränkt, wobei sogar aus Gründen der Wasserlöslichkeit von vornherein auf bestimmte Monomere verzichtet werden muss; Emulsionspolymerisate weisen bekanntermassen sehr hohe Molekulargewichte auf, was sich nachteilig auf Verlauf sowie erreichbare Schichtdicke auswirkt.

In der DE-A Nr. 2853921 werden strahlungshärtbare Bindemitteldispersionen beschrieben, bei denen Dispergierhilfsmittel notwendig sind. Da diese Dispergierhilfsmittel nicht einpolymerisieren, können sie in gewissen Fällen zu unerwünschten Nebeneffekten führen.

Aufgabe der vorliegenden Erfindung ist es, emulgatorfreie, wässerige Bindemittel aufzuzeigen, die sich auf einfache Weise vorteilhaft herstellen und verarbeiten lassen und sich auf verschiedenen Substraten zu kocherfreien, hochglänzenden, strörungsfreien Überzügen sehr hoher Dicke aushärten lassen.

Eine weitere Aufgabe der vorliegenden Erfindung ist es, wässerige Beschichtungsmittel mit hohem Festkörpergehalt aufzuzeigen, die bei der Härtung Polymere mit sehr unterschiedlichem Wasseraufnahmevermögen und definiertem Vernetzungsgrad ergeben.

Es wurde gefunden, dass diese Forderungen erfüllt werden können, wenn man Salze von Mercaptocarbonsäuren an einen Teil der Doppelbindungen eines strahlungshärtbaren Oligomeren oder Polymeren, das mindestens zwei C–C-Doppelbindungen pro Molekül besitzt, zu Thioätherverbindungen addiert, diese Verbindungen mit einem Carboxylgruppengehalt von 0,2 bis 15%, bezogen auf Oligo- bzw. Polymer, zur Herstellung von Dispersionen verwendet und die Beschichtungen nach dem Abdampfen des Wassers durch Bestrahlung härtet.

Auf diesem Wege kann über die Menge der ionischen Gruppen, die an das Polymere direkt addiert werden, der Vernetzungsgrad und die Hydrophilie des Polymeren eingestellt werden. Ausserdem ist über den Gehalt an ionischen Gruppen die Teilchengrösse der Dispersion steuerbar.

Gegenstand der vorliegenden Erfindung sind strahlungshärtbare, emulgatorfreie wässerige Bindemitteldispersionen, bestehend aus

A) 5 bis 80 Gew.-% Wasser,

B) 95 bis 20 Gew.-% eines in A dispergierten polymerisierbaren Bindemittels, und

C) 0 bis 20 Gew.-%, bezogen auf B, mindestens eines Photoinitiators,

die dadurch gekennzeichnet sind, dass das polymerisierbare Bindemittel B ein Thioätheraddukt eines polymerisierbaren Oligo- oder Polymeren ist, das durch Addition von Mercaptocarbonsäuren an nicht wasserlösliche polymerisierbare Oligo- oder Polymere, die mindestens zwei C–C-Doppelbindungen pro Molekül enthalten, erhalten worden ist und ein mittleres Molekulargewicht von mindestens 350, einen Carboxylgruppengehalt von 0,2 bis 15% und einen Gehalt von 0,01 bis 0,8 mol polymerisierbaren C–C-Doppelbindungen 100 g Oligo- bzw. Polymer aufweist, mit der Massgabe, dass die zur Herstellung des Thioätheradduktes verwendeten polymerisierbaren Oligo- oder Polymeren

1. Polyester mit einer Säurezahl von höchstens 10,

2. ungesättigte hydroxylgruppenhaltige Verbindungen, die durch Umsetzung eines Polyepoxids mit durchschnittlich mindestens 2 Epoxidgruppen pro Molekül mit mindestens einer α,β-äthylenisch ungesättigten Carbonsäure hergestellt wurden,

3. gegebenenfalls Harnstoffgruppen enthaltende Polyurethane, die aus aliphatischen und/oder aromatischen Polyisocyanaten durch Umsetzung mit hydroxylgruppenhaltigen (Meth)acrylsäureestern hergestellt wurden, und/oder

4. gegebenenfalls Harnstoffgruppen enthaltende Polyurethane, die aus Polyisocyanaten, organischen Polyhydroxyverbindungen mit einem Molekulargewicht zwischen 400 und 5000, Acrylatdiolen mit Molekulargewichten zwischen 146 und

3000 und gegebenenfalls Diolen oder Triolen hergestellt wurden,
sind.

Gegenstand der Erfindung ist ausserdem ein Verfahren zur Herstellung strahlungshärtbarer wässeriger Bindemitteldispersionen, wobei eine Lösung der Komponente B in einem inerten organischen Lösungsmittel oder Lösungsmittelgemisch mit Wasser gemischt und das inerte organische Lösungsmittel oder Lösungsmittelgemisch destillativ entfernt wird, und gegebenenfalls Komponente C und andere Hilfs- und Zusatzstoffe der Lösung der Komponente B zugefügt werden oder das Wasser nach der destillativen Entfernung des inerten organischen Lösungsmittels oder Lösungsmittelgemisches zugefügt wird.

Auch die Verwendung dieser strahlungshärtbaren wässerigen Bindemitteldispersionen für mittels UV-Strahlung oder beschleunigter Elektronen härtbare Überzugsmittel zur Beschichtung von metallischen und nichtmetallischen Substraten, wobei die Überzugsmittel gegebenenfalls zusätzlich Synergisten für die Komponente C, Pigmente, Füllstoffe, lösliche Farbstoffe, weitere von Komponente B verschiedene Bindemittel und andere in der Lacktechnologie übliche Hilfsmittel enthalten, sowie ihre Verwendung zur Verstärkung von Faservliesen, wobei die Härtung des Bindemittels durch UV-Strahlung oder beschleunigte Elektronen erfolgt, ist Gegenstand der vorliegenden Erfindung.

Bevorzugte strahlungshärtbare Oligo- oder Polymere sind polymerisierbare C–C-Doppelbindungen enthaltende Polyester mit einer Säurezahl von höchstens 10, polymerisierbare C–C-Doppelbindungen enthaltende Polyäther, hydroxylgruppenhaltige Umsetzungsprodukte aus einem mindestens zwei Epoxidgruppen pro Molekül enthaltenden Polyepoxid mit mindestens einer α,β-äthylenisch ungesättigten Carbonsäure, Polyurethan(meth)acrylate sowie α,β-äthylenisch ungesättigte Acylreste enthaltende Acrylcopolymere.

Die Herstellung der Komponente B aus diesen strahlungshärtbaren Oligo- oder Polymeren erfolgt durch Addition von Mercaptosäuren oder deren Salzen, gegebenenfalls in Gegenwart eines Lösungsmittels, bei 0 bis 120, vorzugsweise 20 bis 80° C, an einen Teil der Doppelbindungen zu den entsprechenden carboxylgruppenhaltigen Thioätheraddukten.

Die gestellte Aufgabe wird durch die erfindungsgemässen strahlungshärtbaren wässerigen Bindemitteldispersionen in sehr vorteilhafter Weise gelöst.

Die erfindungsgemässen strahlungshärtbaren wässerigen Bindemitteldispersionen sind praktisch frei von niedrigmolukularen, leichtsiedenden Monomeren, Cosolvenzien und Dispergierhilfsmitteln. Es können damit Beschichtungen auf verschiedenen Substraten hergestellt werden, die sich mittels UV-Strahlung oder Elektronenstrahlen zu kocherfreien hochglänzenden, wasserfesten, störungsfreien Überzügen mit Schichtdicken bis über 100 µm aushärten lassen. Die Vernetzung durch Bestrahlung erfolgt nach vollständiger Verdampfung des Wassers bzw. bei Spritzapplikation zusätzlich nach vollständigem Entweichen der eingeschlossenen Luft.

Zu den einzelnen Komponenten der erfindungsgemässen strahlungshärtbaren wässerigen Bindemitteldispersionen ist folgendes auszuführen:

A) Die komponente A ist Wasser, das in einer Konzentration von 5 bis 80, vorzugsweise 20 bis 80 Gew.-%, vorliegt.

B) Die Komponente B ist ein Thioätheraddukt mit einem Gehalt von 0,01 bis 0,8, vorzugsweise 0,04 bis 0,6 mol/100 g Substanz an polymerisierbaren Doppelbindungen und einem mittleren Molekulargewicht von mindestens 350, sowie einen Carboxylgruppengehalt von 0,2 bis 15%. Das dem Thioätheraddukt zugrundeliegende strahlungshärtbare Oligo- oder Prepolymer kann z.B. sein:

1. ein Polyster mit einer Säurezahl von höchstens 10 aus aliphatischen und/oder aromatischen Dicarbonsäuren, wie Bernstein-, Glutar-, Adipin-, Pimelin-, Kork-, Azelain-, Sebacin-, Cyclohexandicarbon-, Phthal-, Isophthal-, Terephthal-, Malein-, Fumar-, Itakonsäure bzw. deren veresterbaren Derivate, und mehrwertigen Alkoholen, wie Äthylenglykol, Polyäthylenglykole, Propylenglykol, Polypropylenglykole, Butandiol, Hexandiol, Neopentylglykol, Hydroxypivalinsäureneopentylglykolester, Trimethylolpropan, Glycerin, Pentaerythrit, und/oder Trishydroxyäthylisocyanurat sowie α,β-äthylenisch ungesattigten Monocarbonsäuren, beispielsweise Acrylsäure, Methacrylsäure, Krotonsäure, Zimtsäure und/oder Dicarbonsäurehalbester von Monoalkanolen, wie Malein-, Fumar- und Itakonsäurehalbester mit $C_1$ bis $C_4$-Monoalkoholen, wobei Acrylsäure und Methacrylsäure bevorzugt sind, welcher nach den üblichen Verfahren in einem Schritt oder auch stufenweise hergestellt werden kann,

2. eine ungesättigte hydroxylgruppenhaltige Verbindung, die durch Umsetzung eines Polyepoxids mit durchschnittlich mindestens 2 Epoxidgruppen pro Molekül, beispielsweise Polyglycidyläther mehrwertiger Alkohole, wie sie auch unter 1 genannt sind, Polyglycidyläther mehrwertiger Phenole, wie Bisphenol-A, Glycidylester mehrwertiger Carbonsäuren, wie sie auch unter 1 genannt sind, andere Glycidylverbindungen, beispielsweise Triglycidylisocyanurat, und/oder epoxidierte natürliche oder synthetische Öle, mit α,β-äthylenisch ungesättigten Carbonsäuren, wie sie auch unter 1 genannt sind, hergestellt werden kann,

3. ein gegebenenfalls Harnstoffgruppen enthaltendes Polyurethan, das aus aliphatischen und/oder aromatischen Polyisocyanaten, beispielsweise Tetramethylendiisocyanat, Hexamethylendiisocyanat, Isophorondiisocyanat, Diphenylmethandiisocyanat, Toluylendiisocyanat, Naphthylendiisocyanat, 4,4'-Diphenylätherdiisocyanat, gegebenenfalls daraus hervorgehende Di- oder Trimere sowie deren Umsetzungsprodukte mit untergeordneten Mengen Wasserstoffaktiver Verbindungen, wie z.B. mehrwertigen Alkoholen, wie sie auch unter 1 genannt sind, polyfunktionellen Aminen und/oder Aminoalkoholen, durch Umsetzung

mit hydroxylgruppenhaltigen (Meth)acrylsäureestern, wie Hydroxyäthyl(meth)acrylat, Hydroxypropyl(meth)acrylat und/oder Butandiolomono-(meth)acrylat, hergestellt werden kann,

4. ein Polyurethan (Harnstoff), das aus Polyisocyanaten, organischen Polyhydroxyverbindungen mit einem Molekulargewicht zwischen 400 und 5000, Acrylatdiolen mit Molekulargewichten zwischen 146 und 3000 und gegebenenfalls Diolen oder Triolen mit einem Molekulargewicht zwischen 62 und 400 bei einem NCO/OH-Verhältnis zwischen 0,5:1 und 1,3:1 hergestellt wird.

Für die Herstellung der unter 4 genannten Polyurethane eignen sich Acrylesterdiole mit Molekulargewichten zwischen 146 und 3000, z.B. Reaktionsprodukte von Epoxidverbindungen mit polymerisierbaren olefinisch ungesättigten Carbonsäuren, insbesondere Acryl- und Methacrylsäure, wobei jeweils etwa auf jede Epoxidgruppe eine Carboxylgruppe kommt, sowie Reaktionsprodukte von Dicarbonsäuren mit polymerisierbaren olefinisch ungesättigten Glycidylverbindungen, wie sie z.B. in der DE-A Nr. 2164386 beschrieben sind.

Als ungesättigtes Acrylesterdiol eignen sich auch Umsetzungsprodukte aus OH-gruppentragenden Monoepoxiden wie Glycidol mit (Meth)acrylsäure. Geeignete polymerisierbare Diole (Polyole) können z.B. aus Epoxiden mit zwei endständigen Epoxidgruppen gemäss der allgemeinen Formel

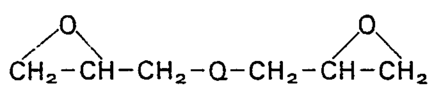

erhalten werden, in der Q ein zweibindiges Radikal beteutet, wie z.B.

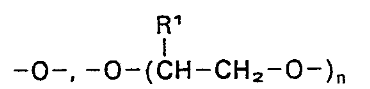

mit n = 1 bis 10, wobei $R^1$ für Wasserstoff oder Methyl steht, d.h. also ein von Äthylenglykol oder Propylenglykol abgeleitetes Radikal, ein $-O-(CH_2)_m-O-$Rest mit m = 1 bis 10 oder wobei dieses Radikal von Polyäthylenglykol oder Polypropylenglykol herleitbar ist, oder Q für den Rest der allgemeinen Formel

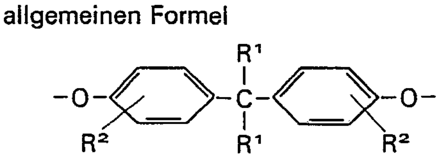

steht, wobei dieses Radikal von 4,4-Dihydroxydiphenylmethan, Bisphenol A oder kernsubstituierten Derivaten dieser Verbindungen hergeleitet werden kann. Die Umsetzung der Epoxidverbindungen mit Acryl- und/oder Methacrylsäure sollten bei der späteren Umsetzung mit Diisocyanaten weitgehend bifunktionell in bezug auf OH-Gruppen sein. Bei einer OH-Funktionalität > 3 besteht sonst die Gefahr der Vernetzung.

Die Umsetzung zwischen den Epoxidverbindungen und den polymerisierbaren olefinisch ungesättigten Säuremonomeren ist eine ringöffnende Veresterung zwischen den Epoxidgruppen der Diepoxidverbindungen und den Carboxylgruppen der polymerisierbaren (Meth)acrylsäure, die etwa analog der DE-A Nr. 2164386 in bekannter Weise ausgeführt werden kann.

Die vorgenannten Epoxidverbindungen und deren Umsetzungsprodukte können allein oder im Gemisch verwendet werden. Bevorzugt eignen sich Umsetzungsprodukte aus Bisphenol A-Diglycidyläther (z.B. ®Epikote 828 der Fa. Shell) oder Glycidol mit Acryl- oder Methacrylsäure.

Die ungesättigten Polyurethane werden dann durch Umsetzen von Diisocyanaten mit den so erhaltenen (Meth)acrylesterdiolen mit einem Molekulargewicht von 146 bis 3000 a, Dihydroxylverbindungen mit einem Molekulargewicht von 400 bis 5000 b und gegebenenfalls Kettenverlängerungsmitteln c in Lösung hergestellt.

Als für die Herstellung der unter 4 genannten Polyurethane geeignete organische Polyhydroxylverbindungen mit Molekulargewichten zwischen 400 und 5000, vorzugsweise zwischen 500 und 4000, sind im wesentlichen lineare Polyester, Polycarbonate, Polylactone (z.B. Polycaprolacton) und Polyäther zu nennen. Ausser endständigen Hydroxylgruppen können derartige Verbindungen auch Carboxyl-, Amino- oder Mercaptogruppen enthalten.

Als geeignete Polyester sind z.B. Veresterungsprodukte von Adipinsäure mit $C_2$ bis $C_{10}$-Alkandiolen oder Oxalkandiolen, als geeignete Polycarbonate z.B. Hexandiolpolycarbonate, zu nennen.

Als gegebenenfalls für die Herstellung der unter 4 genannten Polyurethane mitzuverwendende Diole, Diamine, Aminalkohole oder Triole mit Molekulargewichten zwischen 62 und 400 eignen sich entsprechende Kettenverlängerungsmittel, wie die üblichen gesättigten oder ungesättigten Glykole, wie Äthylenglykol oder Kondensate des Äthylenglykols, Butandiol, Propandiol-1,2, Propandiol-1,3, Neopentylglycol, Dioxäthoxyhydrochinon, Butendiol, Dioxäthyldian, mono- oder bisalkoxylierte aliphatische, cycloaliphatische aromatische oder heterocyclische primäre und sekundäre Amine, wie beispielsweise Äthanolamin, N-Methyläthanolamin, N-Butyläthanolamin, N-Oleyläthanolamin, N-Cyclohexylisopropanolamin, polyäthoxyliertes N-Butyläthanolamin, die aliphatischen, cycloaliphatischen oder aromatischen Diamine, wie Äthylendiamin, Hexamethylendiamin, 1,4-Cyclohexylendiamin, Benzidin, Diaminodiphenylmethan, die Isomeren des Phenylendiamins oder Hydrazin, Aminoalkohole, wie Äthanolamin, Propanolamin oder Butanolamin. Mehrfunktionelle Alkohole wie Trimethylolpropan, Glycerin usw. sollten in weniger als 10 Eq.-% verwendet werden.

Acrylesterdiol, organische Polyhydroxylverbindung und Kettenverlängerungsmittel werden im allgemeinen in Gewichtsmengen von 100: (10 bis 400): (0 bis 30), vorzugsweise 100: (20 bis 300): (1 bis 20), eingesetzt.

Bei der Wahl des Lösungsmittels ist zu beachten, dass bei der Herstellung der Polyurethanmasse kein Lösungsmittel verwendet wird, das unter den Reaktionsbedingungen mit Isocyanatgruppen reagierende funktionelle Gruppen besitzt. Im erfindungsgemässen Verfahren kann jedes beliebige Lösungsmittel eingesetzt werden, das mit der Polyurethanmasse und den Reaktionspartnern nicht in Reaktion tritt. Bevorzugte Lösungsmittel sind gegebenenfalls halogenierte Kohlenwasserstoffe, Ketone, Äther, Ester oder Nitrile, wie z.B. Aceton, Methyläthylketon, Acetonitril, Äthylacetat, Methylenchlorid, Chloroform, Tetrachlorkohlenstoff, Dimethylformamid, Dimethylsulfoxid, Tetrahydrofuran oder Dioxan. Selbstverständlich können auch Mischungen derartiger Lösungsmittel verwendet werden.

Die Herstellung der Polyurethanlösungen kann auf üblichen Wegen erfolgen, z.B. in Masse (im Kessel oder auf Bandanlagen).

Bei einer Synthese auf der Bandanlage werden die Ausgangsprodukte mittels einer Zahnradpumpe flüssig über einen Intensivmischer auf ein langes Band gegeben, welches eine beheizte und gekühlte Zone besitzt. Nachdem das noch nicht ausreagierte PUR das Band verlassen hat, wird es bis zur Vollendung der Polyaddition in der Wärme gelagert und dann gelöst.

*Einstufenreaktion in Lösung:*

Alle Reaktionsteilnehmer werden 20 bis 90%ig, vorwiegend 30 bis 70%ig, in Lösungsmittel in das Reaktionsgefäss eingewogen und auf 20 bis 130° C, vorwiegend auf 30 bis 90° C erwärmt. Das Polymere ist fertig, wenn der gewünschte NCO-Wert erreicht ist (bei Überschuss an Isocyanat) oder wenn alle NCO-Gruppen abreagiert sind (bei Überschuss an H-aktiven Verbindungen);

*Zweistufenreaktion in Lösung:*

Vorreaktion von Polyol und Diisocyanat wird in einem Teil des Lösungsmittels bei vorwiegend 30 bis 90° C durchgeführt, dann wird mit einem Diol und Triol die Kette verlängert. Die weitere Fahrweise entspricht der Einstufenreaktion.

Die Herstellung kann mit Polyurethankatalysatoren, wie sie aus der Polyurethanchemie bekannt sind, beschleunigt werden. Gebräuchliche Katalysatoren sind z.B. metallorganische Verbindungen, wie Dibutylzinndilaurat, tert.-Amine oder Triazine.

Desgleichen eignen sich auch Gemische der unter 1 bis 6 genannten Oligo- und Polymeren (Präpolymeren).

Die Herstellung der Komponente B aus den strahlungshärtbaren Oligo- oder Polymeren erfolgt dadurch, dass man diese mit mercaptogruppenhaltigen Carbonsäuren oder deren Salzen oder Gemischen davon zur Umsetzung bringt. Diese Reaktion wird bei 0 bis 120, bevorzugt bei 20 bis 100° C, durchgeführt. Sie kann durch Verrühren der reinen Komponenten oder in Gegenwart von Lösungsmitteln, wie z.B. Aceton oder Tetrahydrofuran erfolgen.

Als Mercaptocarbonsäuren für das erfindungsgemässe Verfahren eignen sich alle Carbonsäuren, die eine Mercaptogruppe tragen. Besonders geeignet sind Mercaptosäuren, bei denen die Mercaptogruppe in α- oder β-Stellung zur Säuregruppe steht. Die Mercaptosäuren können aliphatisch, cycloaliphatisch, araliphatisch oder aromatisch sein, z.B. Mercaptoessig-, Mercaptopropion-, Mercaptobutter-, Mercaptoisobutter-, Mercaptolinol-, Mercaptotrimethylessig-, Mercaptocyclohexan-, Mercaptophenylessig-, Mercaptobenzoe-, Mercaptotoluylen-, Mercaptochlorbenzoesäure. Ebenfalls geeignet sind Umsetzungsprodukte von Mercaptoäthanol mit Poly- oder Dicarbonsäureanhydriden, Phthalsäureanhydrid oder Trimellithsäureanhydrid, wenn dadurch die SH- Gruppe frei bleibt. Besonders bevorzugt ist Mercaptoessigsäure.

Zur Überführung der Mercaptocarbonsäuren in ihre Salzform geeignete Verbindungen sind z.B.:

1. organische Basen wie monofunktionelle primäre, sekundäre und tertiäre Amine, wie z.B. Methylamin, Diäthylamin, Trimethylamin, Triäthylamin, Äthylamin, Tributylamin, Pyridin, Methyläthylamin, Diäthylmethylamin, Anilin, Toluidin, alkoxylierte Amine, wie z.B. Äthanolamin, Diäthanolamin, Triäthanolamin, Methyldiäthanolamin, Oleyldiäthanolamin sowie polyfunktionelle Amine, bei denen die einzelnen Aminogruppen gegebenenfalls unterschiedliche Basizität aufweisen können, wie z.B. N,N-Dimethyläthylendiamin, α-Aminopyridin, N,N-Dimethylhydrazin, wobei Amine mit einem Siedepunkt von kleiner als 120° C wie z.B. Trimethylamin, Triäthylamin, bevorzugt sind;

2. anorganische Basen, basisch reagierende oder basenabspaltende Verbindungen wie Ammoniak, einwertige Metallhydroxide, -carbonate und -oxide, wie Natriumhydroxid, Kaliumhydroxid; bevorzugte Verbindungen sind Ammoniak, Kaliumhydroxid und Natriumhydroxid.

C) Bei der Komponente C handelt es sich um die bei strahlungshärtbaren Lacken üblichen Photoinitiatoren, wie z.B. Benzophenon, Benzildimethylketal, Benzoinäther, andere aromatische Ketone, Anthrachinon, Thioxanthon bzw. deren Derivate, die in den erfindungsgemässen strahlungshärtbaren wässerigen Überzugsmitteldispersionen in Mengen von 0 bis 20, vorzugsweise 0 bis 10 Gew.-%, bezogen auf B, enthalten sind.

Wenn die erfindungsgemässen Bindemittel mittels UV-Strahlen gehärtet werden, können auch die bei strahlungshärtbaren Lacken üblichen Synergisten für die Komponente C mitverwendet werden. Diese Synergisten können in den erfindungsgemässen strahlungshärtbaren wässerigen Bindemitteldispersionen in Mengen bis 10, vorzugsweise bis 5 Gew.-%, bezogen auf B, enthalten sein. Bevorzugte Synergisten sind z.B. Methyldiäthanolamin und Triäthanolamin.

Gegebenenfalls können den erfindungsgemässen Bindemitteldispersionen auch in der Lacktechnologie übliche Pigmente und/oder Füllstoffe in Mengen bis 500 Gew.-%, bezogen auf die Summe der Komponenten B, zugefügt werden, wobei Rutil, Russ, Talkum, Zinkoxid, Calciumcarbonat, verschiedene Eisenoxide oder organische Pigmente bevorzugt sind. Ausserdem können auch andere in der Lacktechnologie übliche Hilfsstoffe, wie Verlaufmittel, Netzmittel, Entschäumer, lösliche Farbstoffe, Neutralisationsmittel, zusätzliche

unter B nicht genannte Bindemittel, z.B. Aminoplastharze in untergeordneten Mengen, bezogen auf B, in den erfindungsgemässen härtbaren wässerigen Bindemitteldispersionen mitverwendet werden.

Zur Herstellung der erfindungsgemässen strahlungshärtbaren wässerigen Überzugsmitteldispersionen wird die Komponente B in einem inerten organischen Lösungsmittel oder Lösungsmittelgemisch gelöst. Es kann auch die direkt von der Synthese her anfallende Lösung verwendet werden. Geeignete Lösungsmittel sind beispielsweise Tetrahydrofuran, Dioxan, Aceton, Methyläthylketon, Propanole, Butanole, Äthylacetat, Butylacetat, Methylenchlorid, Xylole oder Toluol; bevorzugt sind Methyläthylketon, Tetrahydrofuran, Isopropanol und Isobutanol.

Diese Lösung wird anschliessend gegebenenfalls mit der Komponente C und einem Synergisten für die Komponente C versetzt. Aus der resultierenden Mischung wird das organische Lösungsmittel unter starkem Rühren unter Normaldruck oder im Vakuum destillativ entfernt. Die nach Zufügen von Wasser (gegebenenfalls schon zur Lösung der Komponente B) entstehenden wässerigen Dispersionen weisen Feststoffgehalte von 20 bis 95 Gew.-% auf. Der Restlösungsmittelgehalt liegt unter 3, bevorzugt unter 0,1 Gew.-%, bezogen auf die Gesamtmenge der wässerigen Bindemitteldispersion.

In besonderen Fällen können die 100%igen Komponenten B, die eventuell bereits die Komponente C und Synergist enthalten, durch kräftiges Rühren auch direkt in Wasser eingearbeitet werden.

Die gegebenenfalls mitzuverwendende Komponente C sowie die Hilfsstoffe können selbstverständlich auch unter Anwendung von in der Lacktechnologie üblichen Methoden nachträglich in die fertigen Dispersionen eingearbeitet werden.

Die fertigen Lacke können zur Erzielung optimaler Verarbeitungsviskosität mit Wasser verdünnt werden.

Die erfindungsgemässen strahlungshärtbaren wässerigen Überzugsmitteldispersionen zeichnen sich durch hohe Lagerstabilität aus. Sie sind praktisch frei von organischen Lösungsmitteln und lassen sich mit gutem Erfolg als Beschichtungsmittel für nichtmetallische und metallische Substrate, z.B. für Leder, Kunststoffe, Papier, Holz, Glas, Keramik sowie metallische Untergründe einsetzen, wobei nichtmetallische Untergründe bevorzugt sind. Mit den erfindungsgemässen strahlungshärtbaren wässerigen Bindemitteldispersionen können in nur einem Arbeitsgang kochblasenfreie, hochglänzende Beschichtungen von über 100 µm Dicke erhalten werden.

Die erfindungsgemässen Bindemitteldispersionen lassen sich vorteilhalft auch zur Verstärkung von Faservliesen einsetzen.

Die Verarbeitung der erfindungsgemässen strahlungshärtbaren wässerigen Überzugsmittel erfolgt nach üblichen Methoden, wie durch Streichen, Rakeln, Spritzen, Walzen, Giessen oder Drucken. Zur Härtung werden die Überzüge im allgemeinen bis zu 30 min bei Temperaturen bis 100° C vorgeheizt und anschliessend kurzzeitig einer UV- oder energiereichen Elektronenstrahlung ausgesetzt. Hierzu werden die üblicherweise für die Härtung von Überzügen eingesetzten UV-bzw. Elektronenstrahlungsquellen verwendet, wie z.B. beschrieben in „UV Curing: Science and Technology", Editor: S. Peter Pappas, Technology Marketing Corporation, Stamford, USA, 1978, und „Atomic Radiation and Polymers", Charlesby, Pergamon Press, 1960.

Bei porösen Substraten, wie beispielsweise Leder, Papier, Holz, sind nur sehr kurze Vorheizzeiten erforderlich, da die Hauptmenge des Wassers von Untergrund aufgenommen wird; bisweilen kann auf Vorheizen ganz verzichtet werden.

Gegenüber konventionellen strahlungshärtbaren Beschichtungsmitteln weisen die erfindungsgemässen Überzugsmittel u.a. auch den Vorteil auf, dass keine reaktiven Verdünner (Monomere) und Dispergierhilfsmittel benötigt werden.

Die resultierenden hochglänzenden, dicken Überzüge sind frei von Oberflächenstörungen, beständig gegen organische Lösungsmittel und weisen eine beachtliche Flexibilität, Kratz- und Knitterfestigkeit auf. Wie bei der Applikation als Klarlack deutlich wird, sind die erhaltenen Beschichtungen absolut trübungsfrei.

Als weitere Vorteile der erfindungsgemässen strahlungshärtbaren wässerigen Bindemitteldispersionen sind ihre geringe Toxizität, ihre Umweltfreundlichkeit sowie ihre hohe Wirtschaftlichkeit zu erwähnen. Letzteres gilt insbesondere im Vergleich zu konventionellen Wasserlacken, die selbst zur Erzielung kocherfreier Schichtdicken von nur 60 µm komplizierte, zeitraubende Aufheizprogramme, hohe Einbrenntemperaturen (teilweise bis 200° C) sowie lange Härtungszeiten (mitunter über 30 min) erfordern. Nichtmetallische organische Substrate, wie Leder, Papier oder Holz, scheiden für konventionnelle Wasserlacke aus diesem Grunde ohnehin aus. Diese Untergründe erweisen sich für die erfindungsgemässen strahlungshärtbaren wässerigen Überzugsmittel als besonders vorteilhaft. Mit den erfindungsgemässen Dispersionen können jedoch auch metallische Untergründe mit gutem Erfolg lackiert werden. Hier kommt in erster Linie ein Einsatz für *coilcoating* wegen der Ebenheit der Substrate, der kurzen Vorheizzeiten, insbesondere im Falle dünner Schichten sowie der geringen Härtungszeit in Frage. Im Gegensatz zu konventionellen strahlungshärtbaren Lacken, die aufgrund ihres Monomerengehaltes toxikologisch bedenklich sein können, ist mit den erfindungsgemässen strahlungshärtbaren wässerigen Überzugsmitteln sogar ein Einsatz für die Beschichtung von Lebensmittelbehältern denkbar.

Folgende Beispiele sollen die vorliegende Erfindung näher charakterisieren, ohne diese einzuschränken.

Die angegebenen Teile und Prozente beziehen sich, wenn nicht anders angegeben, auf das Gewicht.

*Beispiel 1*

160 Teile eines Umsetzungsproduktes aus 1 mol Butandioldiglycidäther und 2 mol Acrylsäure werden nach Zugabe von 25 Teilen 4,4'-Diphenylmethandiisocyanat, 123 Teilen Tetrahydrofuran und 0,12 Teilen Dibutylzinndilaurat solange bei 60° C gerührt, bis der NCO-Gehalt 0% beträgt.

Nun wird eine Mischung von 31,3 Teilen 80%iger Mercaptoessigsäure, 27,4 Teilen Triäthylamin und 14,1 Teilen Aceton zugegeben und nach 5stündigem Rühren bei 60° C wird mit 1000 Teilen Wasser unter kräftigem Rühren dispergiert.

Nach dem Entfernen des Lösungsmittels durch Vakuumdestillation verbleibt eine 67,9%ige, stabile Dispersion.

*Beispiel 2*

207 Teile eines Polycaprolactons mit der OH-Zahl 135, 18 Teile Butandiol 1,4, 170,3 Teile 4,4'-Dicyclohexylmethandiisocyanat und 177 Teile einer 68,9%igen acetonischen Lösung von Epikote-828-diacrylat (= Umsetzungsprodukt aus 1 mol ®Epikote 828 und 2 mol Acrylsäure) werden mit Tetrahydrofuran auf 50% verdünnt und nach Zugabe von 0,5 Teilen Dibutylzinnoctoat und 0,25 Teilen Dibutylzinndilaurat solange bei 60° C gerührt, bis der NCO-Gehalt 0% beträgt.

Zu dieser Lösung wird dann eine Mischung von 34,5 Teilen 80%iger Mercaptoessigsäure, 30,3 Teilen Triäthylamin und 15,6 Teilen Aceton gegeben.

Nach einer Reaktionszeit von 30 min bei 60° C wird der Ansatz mit 800 Teilen Wasser unter kräftigem Rühren dispergiert.

Nach dem Abtrennen des Lösungsmittels durch Vakuumdestillation verbleibt eine 39,5%ige, stabile Dispersion.

*Beispiel 3*

500 Teile eines Polyesters mit der OH-Zahl 56, bestehend aus Adipinsäure, Butandiol 1,4 und Glykol, 544 Teile einer 70%igen acetonischen Lösung von Epikote-828-diacrylat (vgl. Beispiel 2), 18 Teile Butandiol und 300 Teile 4,4'-Diphenylmethandiisocyanat werden mit Tetrahydrofuran auf 40% verdünnt und nach Zugabe von 0,4 Teilen Dibutylzinndilaurat und 0,5 Teilen Dibutylzinnoctoat solange bei 60° C gerührt, bis der NCO-Gehalt 0% beträgt.

Zu dieser Lösung wird eine Mischung von 80,5 Teilen 80%iger Mercaptoessigsäure, 70,7 Teilen Triäthamin und 36 Teilen Aceton gegeben.

Nach einer Reaktionszeit von 30 min bei 60° C wird der Ansatz unter kräftigem Rühren mit 1400 Teilen Wasser dispergiert.

Nach der destillativen Abtrennung des Lösungsmittels im Vakuum erhält man eine 39,1%ige stabile Dispersion.

*Beispiel 4*

500 Teile eines Polyesters mit der OH-Zahl 56, bestehend aus Adipinsäure, Butandiol 1,4 und Glykol, 544 Teile einer 68,9%igen acetonischen Lösung von Epikote-828-diacrylat (vgl. Beispiel 2), 18 Teile Butandiol 1,4 sowie 250 Teile 4,4'-Diphenylmethandiisocyanat werden mit Tetrahydrofuran auf 50% verdünnt und nach Zugabe von 0,5 Teilen Dibutylzinnoctoat und 10 Tropfen Dibutylzinndilaurat solange bei 60° C gerührt, bis der NCO-Gehalt 0% beträgt.

Zu dieser Lösung wird eine Mischung von 80,5 Teilen 80%iger Mercaptoessigsäure, 70,7 Teilen Triäthylamin und 36 Teilen Aceton gegeben.

Nach einer Reaktionszeit von 30 min bei 60° C wird der Ansatz mit 1700 Teilen Wasser dispergiert.

Nach Abdestillieren des Lösungsmittels unter Vakuum erhält man eine 44,7%ige stabile Dispersion.

Aufbereitung der Bestrahlungsproben:

In die wässerigen Polymerdispersionen werden 3 Gew.-% UV-Initiator (®Darocur 1173 Fa. Merk) eingerührt. Anschliessend werden die Dispersionen mit einem 80-μ-Kastenrakel auf Weissblech aufgezogen und 5 min bei 80° C getrocknet.

Bestrahlen der Proben:

Die Proben wurden mit einer Geschwindigkeit von 6 m/min an einer Quecksilberhockdrucklampe (Leistungsaufnahme: 80 W/cm) im Abstand von 10 cm vorbeigeführt. Alle Proben ergaben trockene und klebfreie vernetzte Lackfilme. Die Pendelhärten (nach König) der UV-gehärteten Überzüge, die aus den nach Beispiel 1 bis 4 hergestellten Dispersionen erhalten wurden, sind folgende: Beispiel 1: 35; 2:69; 3:32; 4:32.

**Patentansprüche**

1. Strahlungshärtbare, emulgatorfreie wässerige Bindemitteldispersionen, bestehend aus

A) 5 bis 80 Gew.-% Wasser,

B) 95 bis 20 Gew.-% eines in A dispergierten polymerisierbaren Bindemittels, und

C) 0 bis 20 Gew.-%, bezogen auf B, mindestens eines Photoinitiators,

dadurch gekennzeichnet, dass das polymerisierbare Bindemittel B ein Thioätheraddukt eines polymerisierbaren Oligo- oder Polymeren ist, das durch Addition von Mercaptocarbonsäuren an nicht wasserlösliche polymerisierbare Oligo- oder Polymere, die mindestens zwei C–C-Doppelbindungen pro Molekül enthalten, erhalten worden ist und ein mittleres Molekulargewicht von mindestens 350, einen Carboxylgruppengehalt von 0,2 bis 15% und einen Gehalt von 0,01 bis 0,8 mol polymerisierbarer C–C-Doppelbindungen/100 g Oligo- bzw. Polymer aufweist, mit der Massgabe, dass die zur Herstellung des Thioätheraddukts verwendeten polymerisierbaren Oligo- oder Polymeren

1. Polyester mit einer Säurezahl von höchstens 10,

2. ungesättigte hydroxylgruppenhaltige Verbindungen, die durch Umsetzung eines Polyepoxids mit durchschnittlich mindestens 2 Epoxidgruppen pro Molekül mit mindestens einer α, β-

äthylenisch ungesättigten Carbonsäure hergestellt wurden,

3. gegebenenfalls Harnstoffgruppen enthaltende Polyurethane, die aus aliphatischen und/oder aromatischen Polyisocyanaten durch Umsetzung mit hydroxylgruppenhaltigen (Meth)acrylsäureestern hergestellt wurden, und/oder

4. gegebenenfalls Harnstoffgruppen enthaltende Polyurethane, die aus Polyisocyanaten, organischen Polyhydroxyverbindungen mit einem Molekulargewicht zwischen 400 und 5000, Acrylatdiolen mit Molekulargewichten zwischen 146 und 3000 und gegebenenfalls Diolen oder Triolen hergestellt wurden,
sind.

2. Bindemitteldispersion nach Anspruch 1, dadurch gekennzeichnet, dass als polymerisierbares Bindemittel B ein Thioätheraddukt mit einem Molekulargewicht zwischen 1000 und 50 000, einem Carboxylgruppengehalt zwischen 0,5 und 10% und einem Gehalt von 0,01 bis 0,5 mol Doppelbindungen in 100 g Addukt verwendet wird, das durch Umsetzung eines gegebenenfalls Harnstoffgruppen enthaltenden Urethanacrylats mit Mercaptocarbonsäuresalzen erhalten worden ist.

3. Verfahren zur Herstellung strahlungshärtbarer wässeriger Bindemitteldispersionen nach einem der vorhergehenden Ansprüche, dadurch gekennzeichnet, dass eine Lösung der Komponente B in einem inerten organischen Lösungsmittel oder Lösungsmittelgemisch mit Wasser gemischt und das inerte organische Lösungsmittel oder Lösungsmittelgemisch destillativ entfernt wird, wobei gegebenenfalls Komponente C und andere Hilfs- und Zusatzstoffe der Lösung der Komponente B zugefügt werden.

4. Verfahren zur Herstellung strahlungshärtbarer wässeriger Bindemitteldispersionen nach einem der Ansprüche 1 oder 2, dadurch gekennzeichnet, dass aus einer Lösung der Komponente B in einem inerten organischen Lösungsmittel oder Lösungsmittelgemisch, die gegebenenfalls Komponente C und andere Hilfs- und Zusatzstoffe enthält, das inerte organische Lösungsmittel oder Lösungsmittelgemisch destillativ entfernt und dann Wasser zugefügt wird.

5. Verwendung der strahlungshärtbaren wässerigen Bindemitteldispersionen nach einem der Ansprüche 1 bis 4 für mittels UV-Strahlung oder beschleunigter Elektronen härtbare Überzugsmittel zur Beschichtung von metallischen und nichtmetallischen Substraten, wobei die Überzugsmittel gegebenenfalls zusätzlich Synergisten für die Komponente C, Pigmente, Füllstoffe, lösliche Farbstoffe, weitere von Komponente B verschiedene Bindemittel und andere in der Lacktechnologie übliche Hilfsmittel enthalten.

6. Verwendung der strahlungshärtbaren wässerigen Bindemitteldispersionen nach einem der Ansprüche 1 bis 4 zur Verstärkung von Faservliesen, wobei die Härtung des Bindemittels durch UV-Strahlung oder beschleunigte Elektronen erfolgt.

**Claims**

1. A radiation-curable, emulsifier-free aqueous binder dispersion consisting of

(*A*) 5 to 80 % by weight of water,

(*B*) 95 to 20 % by weight of a polymerizable binder dispersed in A, und

(*C*) 0 to 20 % by weight, based on B, of at least one photo-initiator

wherein the polymerizable binder B is a thio-ether adduct of a polymerizable oligomer or polymer which has been obtained by the addition of a mercaptocarboxylic acid to a water-insoluble polymerizable oligomer or polymer containing at least two carbon–carbon double bonds per molecule, and has a mean molecular weight of at least 350, and contains 0.2 to 15 % of carboxyl groups, and 0.01 to 0.8 mol of polymerizable carbon–carbon double bonds per 100 g of oligomer or polymer, with the proviso that the polymerizable oligomer or polymer used for the production of the thio-ether adduct is

(1) a polyester having an acid number of not more than 10,

(2) an unsaturated hydroxyl-containing compound which has been obtained by reacting a polyepoxide, having an average of at least two epoxide groups per molecule, with at least one α, β-ethylenically unsaturated carboxylic acid,

(3) a polyurethane optionally containing urea groups which has been obtained from an aliphatic and/or aromatic polyisocyanate by reaction with a hydroxyl-containing acrylate or methacrylate, and/or

(4) a polyurethane optionally containing urea groups which has been obtained from a polyisocyanate, an organic polyhydroxyl compound having a molecular weight of from 400 to 5,000, and an acrylate diol having a molecular weight of from 146 to 3,000, with or without a diol or triol.

2. A binder dispersion as claimed in claim 1, wherein a thio-ether adduct having a molecular weight of from 1,000 to 50,000, and containing 0.5 to 10 % of carboxyl groups, and 0.01 to 0.5 mol of double bonds per 100 g of adduct, which has been obtained by reacting a urethane acrylate optionally containing urea groups with a mercaptocarboxylic acid salt, is used as polymerizable binder B.

3. A process for the production of a radiation-curable aqueous binder dispersion as claimed in one of the preceding claims, wherein a solution of component B in an inert organic solvent or solvent mixture is mixed with water, and the inert organic solvent or solvent mixture is removed by distillation, it being possible, if desired, to add component C and other auxiliaries and additives to the solution of component B.

4. A process for the production of a radiation-curable aqueous binder dispersion as claimed in claim 1 or 2, wherein the inert organic solvent or solvent mixture is removed by distillation from a solution of component B in an inert organic solvent or solvent mixture, which solution may or

may not contain component C and other auxiliaries and additives, and then water is added.

5. The use of a radiation-curable aqueous binder dispersion as claimed in any of claims 1 to 4 for coating materials for coating metal and non-metal substrates, which coating materials can be cured by UV radiation or accelerated electrons, and may, if desired, additionally contain a synergist for component C, pigments, fillers, soluble dyes, other binders different from component B, and other auxiliaries usually used in surface coatings.

6. The use of a radiation-curable aqueous binder dispersion as claimed in any of claims 1 to 4 for reinforcing non-woven fibrous products, curing of the binder being effected by UV radiation or accelerated electrons.

## Revendications

1. Dispersions de liant, aqueuses, sans émulsifiant, durcissables aux rayonnements, constituées de

A) 5 à 80 % en poids d'eau,

B) 95 à 20 % en poids d'un liant polymérisable, dispersable dans A, et

C) 0 à 20 % en poids, rapportés à B, d'au moins un photo-initiateur,

caractérisées par le fait que le liant polymérisable B est un produit d'addition thioéther d'un oligo- ou polymère polymérisable, qui a été obtenu par addition d'acides mercaptocarboxyliques sur des oligo- ou polymères, polymérisables, non solubles dans l'eau, qui contiennent au moins deux doubles liaisons C–C par molécule, et qui possède un poids moléculaire moyen d'au moins 350, une teneur en groupes carboxyle de 0,2 à 15 %, et 0,01 à 0,8 mol de doubles liaisons C–C polymérisables par 100 g d'oligo- ou polymère, sous réserve que les oligo- ou polymères polymérisables, utilisés pour la préparation du produit d'addition thioéther, soient

1. des polyesters d'un indice d'acide d'au maximum 10,

2. des composés insaturés, à groupes hydroxyle, qui ont été préparés par réaction d'un polyépoxyde à, en moyenne, au moins 2 groupes époxyde par molécule, avec au moins un acide carboxylique à insaturation éthylénique en α, β,

3. des polyuréthanes, contenant éventuellement des groupes urée, qui ont été préparés, à partir de polyisocyanates aliphatiques et/ou aromatiques, par réaction avec des esters d'acides (méth)acryliques à groupes hydroxyle, et/ou

4. des polyuréthanes, contenant éventuellement, des groupes urée, qui ont été préparés à partir de polyisocyanates, de composés polyhydroxylés organiques, d'un poids moléculaire compris entre 400 et 5000, d'acrylatediols, d'un poids moléculaire compris entre 146 et 3000 et, éventuellement, de diols ou triols.

2. Dispersion de liant selon la revendication 1, caractérisée par le fait que l'on utilise, comme liant polymérisable B, un produit d'addition thioéther d'un poids moléculaire compris entre 1000 et 50 000, d'une teneur en groupes carboxyle comprise entre 0,5 et 10 % et contenant 0,01 à 0,5 mol de doubles liaisons par 100 g de produit d'addition, qui a été obtenu par réaction d'un acrylate d'uréthanne, contenant éventuellement des groupes urée, avec des sels d'acides mercaptocarboxyliques.

3. Procédé de préparation de dispersions de liant aqueuses, durcissables aux rayonnements, selon l'une des revendications précédentes, caractérisé par le fait qu'on mélange, avec de l'eau, une solution du composant B dans un solvant, ou mélange de solvants, organique, inerte, et en ce qu'on élimine par distillation le solvant, qu'on mélange le solvant, organique, inerte, des composants C et d'autres auxiliaires et additifs étant éventuellement ajoutés à la solution du composant B.

4. Procédé de préparation de dispersions de liant aqueuses, durcissables aux rayonnements, selon l'une des revendications 1 ou 2, caractérisé par le fait que, d'une solution du composant B dans un solvant, ou mélange de solvants, organique, inerte, qui contient, éventuellement, des composants C et autres additifs et auxiliaires, on élimine par distillation le solvant ou mélange de solvants, organique, inerte, puis en ce qu'on ajoute de l'eau.

5. Utilisation des dispersions de liant, aqueuses, durcissables aux rayonnements selon l'une des revendications 1 à 4, pour produit d'enduction, durcissable au moyen de rayonnement UV ou d'électrons accélérés, pour revêtir des substrats métalliques ou non métalliques, le produit d'enduction contenant éventuellement, en plus, des synergistes pour les composants C, des pigments, charges, colorants solubles, d'autres liants différents des composants B et autres auxiliaires, usuels en technique des peintures et vernis.

6. Utilisation des dispersions de liant, aqueuses, durcissables aux rayonnements selon l'une des revendications 1 à 4 pour le renforcement de voiles de fibres, le durcissement du liant résultant de rayonnement UV ou d'électrons accélérés.